Europäisches Patentamt

European Patent Office

Office européen des brevets

(11) Numéro de publication: **0 514 637 A1**

# DEMANDE DE BREVET EUROPEEN

(21) Numéro de dépôt: **92104339.4**

(22) Date de dépôt: **13.03.92**

(51) Int. Cl.5: **H01L 23/498**, H01L 23/495

(30) Priorité: **28.03.91 FR 9103941**

(43) Date de publication de la demande:
**25.11.92 Bulletin 92/48**

(84) Etats contractants désignés:
**AT CH DE GB IT LI NL**

(71) Demandeur: **EM Microelectronic-Marin SA**

**CH-2074 Marin(CH)**

(72) Inventeur: **Vuilleumier, Jean-Claude**
**Planches-Vallier 5**
**CH-2088 Cressier(CH)**
Inventeur: **Juan, Alain**
**Chemin des Esserts 30**
**CH-2054 Chézard(CH)**

(74) Mandataire: **de Raemy, Jacques**
**ICB Ingénieurs Conseils en Brevets SA**
**Passage Max. Meuron 6**
**CH-2001 Neuchâtel(CH)**

(54) **Composant électronique ultramince et procédé pour sa fabrication.**

(57) Le composant électronique (2) comporte au moins une puce à circuit intégré (10) qui présente une face avant (11) munie d'électrodes et une face arrière (12). Un réseau de conducteurs (4) est lié électriquement aux électrodes de la puce pour former des pattes (39) de connexion d'entrée et de sortie du composant.

La face (11) avant de la puce et au moins une portion des pattes (39) sont recouvertes d'une feuille de protection collée (50) pour former ainsi un composant complet, prêt à être associé par exemple à un circuit imprimé. Un cadre (51) de même épaisseur que la puce entoure cette dernière.

La feuille de protection (50) et le cadre (51) remplacent l'encapsulation usuellement mise en oeuvre dans ce genre de composant de telle sorte que le composant proposé présente une épaisseur très réduite.

Fig. 1

La présente invention est relative à un composant électronique comportant au moins une puce à circuit intégré, ladite puce présentant une face avant munie d'électrodes et une face arrière, et un réseau de conducteurs lié électriquement auxdites électrodes pour former des pattes de connexion d'entrée et/ou de sortie du composant, la face avant de ladite puce et au moins une portion desdites pattes de connexion étant recouverte d'une feuille de protection collée pour former un composant prêt à être associé à un circuit imprimé.

La puce constituant le composant électronique est généralement protégée par un boîtier dans lequel elle est encapsulée. De ce boîtier, présentant souvent une forme rectangulaire ou carrée, sortent des pattes de connexion disposées sur deux rangées opposées, chacune disposée en ligne. La disposition DIL (dual in line) présente des pattes pliées à l'équerre qu'on vient introduire dans un circuit imprimé percé de trous. La disposition SO (small outline) ou encore SOT (small outline transistor) présente des pattes pliées de telle façon qu'elle convient au montage dit de surface (SMD). Qu'on choisisse l'une ou l'autre des dispositions citées, la puce avec ses pattes est moulée dans de la matière plastique qui confère au composant une certaine épaisseur. Pour les composants les plus minces qui soient connus, par exemple le type SOT 144, cette épaisseur n'est guère inférieure à 0,85 mm.

Pour certains dispositifs de petites dimensions, comme par exemple une montre-bracelet, il est souhaitable de proposer un composant moins encombrant si l'on veut réduire encore l'épaisseur hors-tout du dispositif. Dans ce but, le document JP-A-56 069 850, patent abstracts of Japan, vol. 005, No 133 (E-071) du 25 août 1981, propose un composant électronique dans lequel la face avant de la puce et au moins une portion des pattes de connexion sont recouvertes d'une feuille de protection collée pour former un composant prêt à être associé à un circuit imprimé. Un tel arrangement permet de diminuer l'épaisseur du composant bien en-dessous des 0,85 mm obtenus avec encapsulation totale.

Cette exécution présente cependant l'inconvénient de ne protéger la puce que sur sa face avant. De même, les pattes de connexion ne sont pas protégées au-delà des plots de connexion se trouvant sur la puce et sur lesquels elles sont soudées. Ainsi pour pallier ces inconvénients, le composant de la présente invention présente des pattes de connexion qui reposent en outre sur un cadre présentant une ouverture dans laquelle la puce est introduite, l'épaisseur que présente le cadre étant sensiblement la même que l'épaisseur de la puce, la feuille de protection collée recouvrant également ledit cadre. Ainsi, par rapport à l'art antérieur cité, la puce est mieux protégée puisque entourée par un cadre. De même les pattes de connexion sont soutenues par ce même cadre et sont ainsi rendues moins fragiles.

La présente invention concerne également un procédé pour fabriquer le composant en question.

L'invention va être comprise maintenant à la lecture de la description suivante qui s'appuie sur le dessin montrant en exemple un mode de réalisation préféré de l'invention ainsi qu'un procédé pour sa fabrication.

- La figure 1 montre en perspective le composant électronique selon l'invention, et
- la figure 2 illustre un procédé de fabrication en séries du composant selon la figure 1.

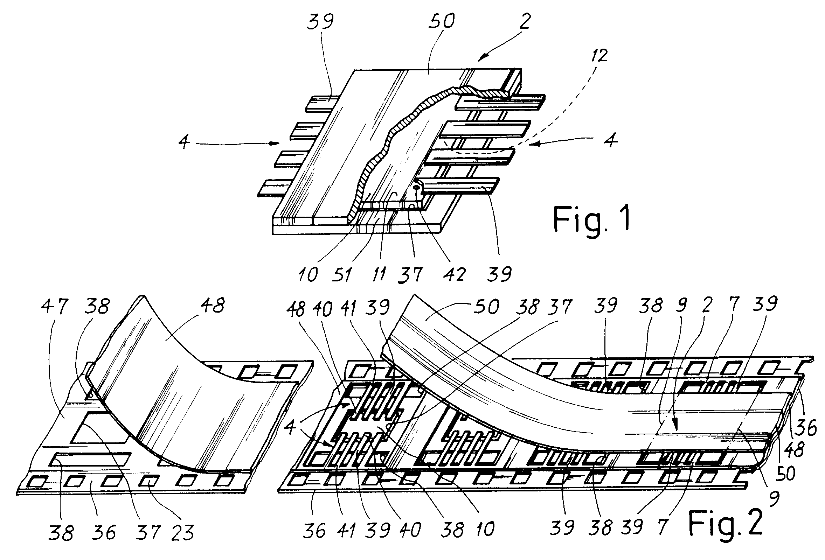

Le composant électronique 2 représenté à la figure 1 comporte une puce à circuit intégré 10 comprenant une face avant 11 munie d'électrodes 42 et une face arrière 12. Un réseau de conducteurs 4 est lié électriquement aux électrodes 42 pour former des pattes de connexion 39 d'entrée et/ou de sortie du composant. Comme cela apparaît bien à la figure 1, la face avant 11 de la puce 10 et au moins une portion des pattes 39 sont recouvertes par une feuille de protection collée 50. Selon une caractéristique importante de l'invention, on remarque que les pattes de connexion 39 reposent sur un cadre 51 qui présente une ouverture 37 dans laquelle est introduite la puce 10. Comme le montre la figure 1, l'épaisseur du cadre 51 est sensiblement égal à l'épaisseur de la puce 10 et la feuille de protection collée 50 recouvre également le cadre 51. La colle est suffisamment épaisse pour remplir l'espace existant entre la face avant de la puce et le dessous de la feuille de protection. De manière identique, la colle va remplir les interstices se trouvant entre les pattes 39 et partiellement au moins l'interstice existant entre la puce 10 et l'ouverture 37 du cadre 51.

On obtient alors un composant ultramince et cela en faisant l'économie d'une encapsulation totale. La protection de la puce est cependant meilleure puisque la puce est protégée dans sa périphérie, entourée qu'elle est du cadre 51.

En ce qui concerne l'épaisseur du composant terminé, il ne dépassera pas 500 μm. Cette dimension est atteinte avec une puce présentant une épaisseur de 225 μm, une épaisseur de pattes de 50 μm et une épaisseur de feuille de protection de 150 μm, l'épaisseur du cadre 51 étant de l'ordre de 225 μm. La feuille de protection peut être réalisée en polyimide, en polyester ou encore en verre époxy.

La colle utilisée peut être du type Pyralux (marque déposée) de la Société Dupont de Nemours. Cette colle peut être appliquée sur la face avant de la puce et sur les pattes. En variante, on peut fournir une feuille de protection déjà enduite de colle, Au moment du collage de la feuille qui se fait de préférence sous pression, on chauffe le tout à une température d'environ 120 degrés ce qui, d'une part, rend la colle plus liquide et lui permet de bien pénétrer dans les espaces à remplir et, d'autre part, permet la polymérisation de ladite colle.

On va décrire maintenant un procédé de fabrication en séries du composant électronique montré en figure 1. On se reportera pour cela à la figure 2.

On commence par fournir une bande isolante 36 pourvue de perforations 23 qu'on enduit de matière adhésive 47. Il s'agit par exemple d'un film normalisé 35 mm. Dans cette bande, on pratique une série de premières ouvertures 37 dont les dimensions sont légèrement plus grandes que les dimensions périphériques de la puce 10. On associe à chaque première ouverture 37 deux secondes ouvertures 38 sensiblement rectangulaires situées chacune à proximité de la première ouverture et de part et d'autre de celle-ci. Ces opérations sont visibles sur la partie gauche de la figure 2. On applique ensuite sur la matière adhésive 47 une feuille métallique 48 qu'on grave chimiquement pour obtenir la configuration montrée au début de la seconde partie de la figure 2. A la première ouverture 37 est associé un réseau 4 de conducteurs disposé de part et d'autre de ladite première ouverture et comportant des pattes de connexion 39 allongées perpendiculairement à la direction longitudinale de la bande et traversant de surcroît les secondes ouvertures 38. La figure 2 montre que les pattes 39 présentent des premières extrémités libres 40 tombant au droit des électrodes (non visibles) de la puce 10 devant être liée au réseau et des secondes extrémités 41 restant attachées à la feuille métallique 48. Au réseau de conducteurs 4, la seconde partie de la figure 2 montre qu'on a associé une puce 10 et ceci par soudage de ses électrodes sur les premières extrémités 40 des pattes constituant le réseau. Sur la bande ainsi préparée, on applique alors une feuille isolante de protection 50 enduite de colle, la largeur de cette feuille étant dimensionnée de telle façon que la portion des pattes 39 traversant les secondes ouvertures 38 dépassent de la feuille de protection 50, comme on le voit bien sur la partie de droite de la figure 2. On sectionne ensuite de la feuille métallique 48 les secondes extrémités 41 des pattes 39 selon les pointillés 7, ce qui permet le contrôle électrique du composant, ce dernier restant encore attaché à la bande par la feuille isolante de protection 50. Enfin, on sépare le composant de la bande par sectionnement de la feuille isolante 50 et de la bande isolante sous-jacente 36 selon les pointillés 9. On obtient alors le composant 2 illustré en figure 1 où le cadre 51 provient du découpage de la bande isolante de base 36. On fera remarquer que le composant 2 pourra être livré individuellement, auquel cas la découpe 9 suivra immédiatement le contrôle électrique, ou encore attaché à la bande, l'utilisateur se chargeant de la découpe 9. On remarquera aussi que pour consolider le tout, en plus de la colle déjà utilisée, il est loisible d'utiliser une masse résineuse qui remplit l'espace entre la puce et les parois du cadre dans lequel elle est introduite, cette protection supplémentaire étant connue sous le nom de potting.

On mentionnera pour terminer que le composant selon l'invention n'est pas limité à l'utilisation d'une puce à circuit intégré comportant deux rangées de quatre pattes. Ces pattes pourraient être moins nombreuses ou plus nombreuses, cela dépendant des fonctions à assurer par la puce.

## Revendications

1. Composant électronique (2) comportant au moins une puce à circuit intégré (10), ladite puce présentant une face avant (11) munie d'électrodes (42) et une face arrière (12), et un réseau (4) de conducteurs lié électriquement auxdites électrodes pour former des pattes (39) de connexion d'entrée et/ou de sortie du composant, la face avant de ladite puce et au moins une portion desdites pattes de connexion étant recouvertes d'une feuille de protection collée (50) pour former un composant prêt à être associé à un circuit imprimé, caractérisé par le fait que les pattes de connexion (39) reposent en outre sur un cadre (51) présentant une ouverture (37) dans laquelle la puce (10) est introduite, l'épaisseur que présente le cadre étant sensiblement la même que l'épaisseur que présente la puce, la feuille de protection collée (50) recouvrant également ledit cadre.

2. Procédé de fabrication en séries de composants électroniques (2) comme définis en revendication 1, caractérisé par le fait qu'il comporte la succession des étapes suivantes :
   - on fournit une bande isolante perforée (36) qu'on enduit de matière adhésive (47),
   - on pratique dans la bande une série de premières ouvertures (37) dont les dimensions sont légèrement plus grandes que les dimensions périphériques de la puce (10) et, pour chaque première ouverture, deux secondes ouvertures (38) sensiblement rectangulaires situées chacune à proximité de ladite première ouverture et de part et d'autre de celle-ci,
   - on applique une feuille métallique (48) sur ladite matière adhésive et on grave chimiquement ladite feuille pour associer à chaque première ouverture (37) un réseau (4) de conducteurs disposé de part et d'autre de ladite première ouverture et comportant des pattes de connexion (39) allongées perpendiculairement à la direction longitudinale de la bande et traversant lesdites secondes ouvertures (38), lesdites pattes présentant des premières extrémités libres (40) tombant au droit des électrodes (42) de la puce (10) devant être liée au réseau et des secondes extrémités (41) restant attachées à la feuille (48),

- à chaque réseau (4) de conducteurs, on associe une puce (10) à circuit intégré par soudage des électrodes de ladite puce sur les premières extrémités libres (40) des pattes composant ledit réseau,

- on applique une feuille isolante de protection (50) enduite de colle sur la bande ainsi préparée, la largeur de la feuille étant dimensionnée de telle façon que la portion des pattes (39) traversant lesdites secondes ouvertures (38) dépassent de ladite feuille de protection,

- on sectionne de la feuille métallique (48) les secondes extrémités (41) des pattes (39) pour permettre le contrôle électrique du composant, ce dernier restant encore attaché à la bande par la feuille isolante de protection (50), et

- on sépare le composant de la bande par sectionnement de la feuille isolante (50) et de la bande isolante sous-jacente (36) pour obtenir un desdits composants électroniques (2).

Fig. 1

Fig. 2

European Patent
Office

**EUROPEAN SEARCH REPORT**

Application Number

EP    92 10 4339

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | PATENT ABSTRACTS OF JAPAN vol. 013, no. 493 (E-842)8 November 1989 & JP-A-01 196 840 ( TOSHIBA CORP. ) 8 August 1989 * abstract * | 1,2 | H01L23/498 H01L23/495 |
| A | US-A-4 907 061 (M. KOHARA) * column 1, line 51 - column 2, line 5; figure 5 * | 1 | |
| A | PATENT ABSTRACTS OF JAPAN vol. 005, no. 133 (E-071)25 August 1981 & JP-A-56 069 850 ( CITIZEN WATCH CO LTD. ) 11 June 1981 * abstract * | 1 | |
| A | PATENT ABSTRACTS OF JAPAN vol. 011, no. 026 (P-539)24 January  1987 & JP-A-61 196 391 ( MATSUSHITA ELECTRIC IND CO LTD. ) 30 August 1986 * abstract * | 1,2 | |
| A | PATENT ABSTRACTS OF JAPAN vol. 014, no. 411 (E-0973)5 September 1990 & JP-A-02 155 248 ( NEC CORP. ) 14 June 1990 * abstract * | 1,2 | TECHNICAL FIELDS SEARCHED (Int. Cl.5 ) H01L |
| A | EP-A-0 307 773 (EM MICROELECTRONIC-MARIN SA) * page 4, column 5, line 49 - page 4, column 6, line 49 * * page 5, column 7, line 50 - page 5, column 8, line 11 * * page 6, column 10, line 32 - page 7, column 11, line 2; figures 2C,2D,8 * | 1 | |
| A | PATENT ABSTRACTS OF JAPAN vol. 012, no. 369 (E-665)4 October 1988 & JP-A-63 122 131 ( HITACHI LTD. ) 26 May 1988 * abstract * | 1 | |

The present search report has been drawn up for all claims

| Place of search | Date of completion of the search | Examiner |
|---|---|---|
| THE HAGUE | 10 JULY 1992 | ZEISLER P.W. |